# EUROPEAN PATENT APPLICATION

(11) **EP 2 360 757 A2**
(43) Date of publication of application: **24.08.2011**
(21) Application number: 09829278.2
(22) Date of filing: 12.11.2009
(51) Int. Cl.: H01M 2/30

(54) **HIGH OUTPUT ELECTRICAL ENERGY STORAGE DEVICE**

(30) Priority: 26.11.2008 KR 20080118302
(71) Applicant: Kim's Techknowledge Inc., Daejeon 305-434 (KR)
(72) Inventor: KIM, Seong Min, Daejeon 305-335 (KR)
(74) Representative: Molnia, David
(86) International application number: PCT/KR2009/006659
(87) International publication number: WO 2010/062071

(57) **Abstract**

The present invention relates to an electric energy storage device such as capacitors, secondary batteries, and the like, and more particularly, to an electric energy storage device in which high output characteristics are improved through the use of voltage terminals. The electric energy storage device according to the present invention comprises a positive electrode and a negative electrode for storing electrical energy, a positive electrode current terminal and a negative electrode current terminal connected to the respective positive electrode and the negative electrode to provide current thereto; and a positive electrode voltage terminal and a negative electrode voltage terminal connected to the positive electrode and the negative electrode to detect voltage between the positive electrode and the negative electrode. The device of the present invention controls charging or discharging operation by using the detected voltage as control voltage.

## Description

### [Technical Field]

The present invention relates to an electric energy storage device such as a capacitor, a secondary battery, or the like, and more particularly, to an electric energy storage device capable of improving high output characteristics by connecting a voltage terminal to an electrode of the electric energy storage device and using voltage measured at the voltage terminal as control voltage.

### [Background Art]

An electric energy storage device has some degree of electric resistance according to a structure and a material thereof. When the electric energy storage device is used as an industrial device using large power or a device for driving a car, a great difference between actually stored voltage and measured voltage may occur due to the electric resistance.

That is, when voltage is measured in the state where current is applied to the electric energy storage device, voltage drop occurs due to resistance of a current moving path. Therefore, when voltage is measured by an electrode applied with current in this state, it may be difficult to accurately measure voltage since the voltage includes the actual voltage of the electrode and a voltage drop component due to the resistance of the current moving path.

### [Disclosure]

### [Technical Problem]

The present invention has been made in an effort to provide an electric energy storage device capable of accurately measuring actual voltage stored at a terminal by removing voltage drop due to current.

### [Technical Solution]

In order to achieve the above-mentioned objects, an electric energy storage device according to an exemplary embodiment of the present invention includes: a positive electrode and a negative electrode storing electric energy and a positive current terminal and a negative current terminal connected to the positive electrode and the negative electrode to apply current; and a positive voltage terminal and a negative voltage terminal connected to the positive electrode and the negative electrode to detect voltage across the positive electrode and the negative electrode, wherein the charging and discharging operation is controlled by using the detected voltage across the positive electrode and the negative electrode as control voltage.

### [Advantageous Effects]

As set forth above, the exemplary embodiment of the present invention can more accurately measure the voltage than the related art since the voltage drop component due to the resistance may be removed by attaching the voltage terminals to the electrodes of the electric energy storage device and measuring the voltage by the voltage terminals.

Further, the exemplary embodiment of the present invention can improve the large current characteristics of the electric energy storage device by using the voltage at both ends detected through the voltage terminals as the control voltage, thereby improving the charging or discharging efficiency of the electric energy storage device.

Furthermore, the exemplary embodiment of the present invention can perform the charging and discharging based on the accurate voltage, thereby actually improving the available capacity of the electric energy storage device.

In addition, the exemplary embodiment of the present invention can improve the large current characteristics by using the voltage terminals and the current terminals as compared with the existing storage device, thereby improving the charging and discharging performance.

### [Description of Drawings]

FIG. 1 is a structural diagram of unit cells of an electric energy storage device such as a battery or a capacitor.
FIG. 2 is a perspective view of an electrode that may be used as a positive electrode or a negative electrode in a unit cell.
FIG. 3 is a perspective view showing an arrangement of an electrode and a terminal in a unit cell.
FIG. 4 is a perspective view showing an arrangement of an electrode assembly and a terminal.
FIG. 5 is a perspective view showing an arrangement before a multilayered electric double layer capacitor is stacked.
FIG. 6 is a graph showing voltage and current at the time of charging or discharging constant current of the electric double layer capacitor.
FIG. 7 is an equivalent circuit diagram of resistors of the electric energy storage device shown in FIG. 3.
FIG. 8 is a perspective view showing an arrangement state of the electrode and the terminal of the electric double layer capacitor according to an exemplary embodiment of the present invention.
FIG. 9 to 11 are a schematic diagram showing a method of connecting a voltage lead to an electrode according to the exemplary embodiment of the present invention.
FIGS. 12 and 13 are perspective views of the structure of the electric double layer capacitor according to the exemplary embodiment of the present invention.
FIG. 14 is a perspective view of a serial electric double layer capacitor according to the exemplary embodiment of the present invention.
FIG. 15 is an equivalent circuit diagram of the resistors of the unit cells of the electric double layer capacitor shown in FIG. 10.
FIG. 16 is a graph showing a charging and discharging behavior of the electric double layer capacitor according to the exemplary embodiment of the present invention.

### [Best Mode]

Hereinafter, exemplary embodiments of the present invention will be described in detail with reference to the accompanying drawings.

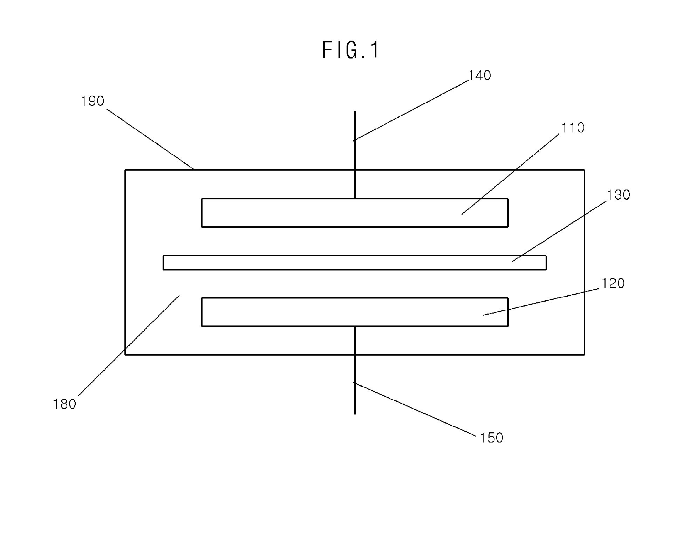

FIG. 1 is a structure diagram of unit cells of an electric energy storage device such as a battery, a capacitor, or the like.

As shown in FIG. 1, the unit cells of the electric energy storage device may be configured to include a positive electrode 110, a negative electrode 120, a separator 130, a positive terminal 140, a negative terminal 150, an electrolyte 180, and a case 190.

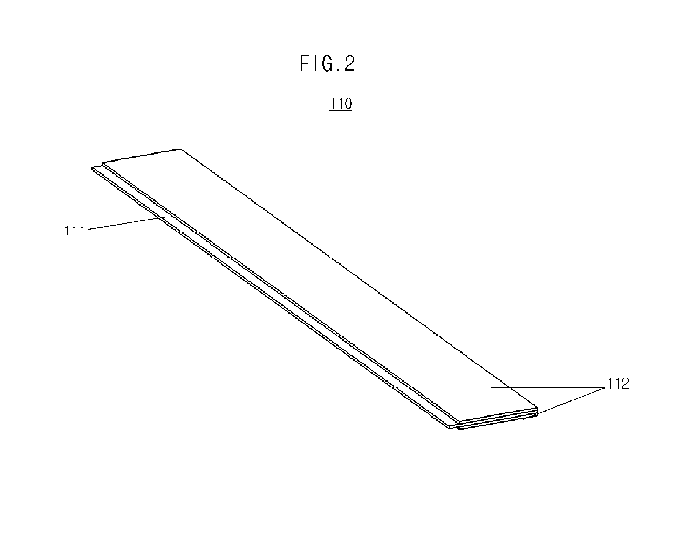

The positive electrode 110 and the negative electrode 120 are stored with electric energy. Generally, the positive electrode 110 and the negative electrode 120 are configured as an active material and a current collector. The configuration of these electrodes 110 and 120 will be described with reference to FIG. 2.

The electrolyte 180, which is a moving medium of ions, may store electric energy in the active material through the ions. The electrolyte 180 is a necessary component in an electrochemical or electrolytic cell such as a battery, an electric double layer capacitor, an aluminum electrolytic capacitor, but is not necessary in an electrostatic cell such as a film capacitor.

The separator 130 is inserted into the positive electrode 110 and the negative electrode 120 to electrically isolate two electrodes from each other. However, when electrically insulating between the positive electrode 110 and the negative electrode 120, the unit cells may be configured without the separator 130.

When a liquid electrolyte such as the secondary battery, the electric double layer capacitor, and the aluminum electrolytic capacitor is used, a porous sheet, such as paper or fiber, that transmits the ions of the liquid electrolyte but is an electrical nonconductor may be used as the separator 130.

The terminals 140 and 150, which serve as a path through which the electric energy is transferred to the electric energy storage device, may be applied in various forms for each application.

A case 190, which isolates the electric energy storage device from the outside, may be configured of various materials and in various shapes according to a type of the electric energy storage device.

FIG. 2 is a perspective view of an electrode that may be used as the positive electrode or the negative electrode in a unit cell. Hereinafter, the positive electrode 110 will be described as an example.

As shown in FIG. 2, the electrode 110 is configured to include the current collector 111 and the active material layer 112.

The active material layer 112 serves to store electric energy and the current collector 111 serves as a path through which the electric energy of the active material layer may move.

In the case of the electric double layer capacitor, activated carbon is used as the active material and an aluminum sheet may be mainly used as the current collector 111. In particular, in order to improve adhesion with the active material layer, the aluminum sheet of which the surface is subjected to etching treatment may be used. Then, the electrode 110 may be formed by preparing the active material layer 112 into slurry or paste by mixing the activated carbon and a binder on a powder, a conductivity improving agent, and a solvent and then, directly applying the slurry or paste to the current collector 111 using a method such as roll coating or by preparing an active material sheet using a method such as calendaring and then, bonding the active material sheet to the current collector 111 using a conductive adhesive.

On the other hand, in the case of the aluminum electrolytic capacitor, the electrode 110 may be configured by forming the active material layer 112 by performing the etching-treatment of the active material on the aluminum sheet current collector 111.

As shown in FIG. 2, in the case of the electrode, the active material layers 112 are generally formed on both surfaces of the current collector 111 and in the case of the electric double layer capacitor, the same active material may be used on the positive electrode 110 and the negative electrode 120.

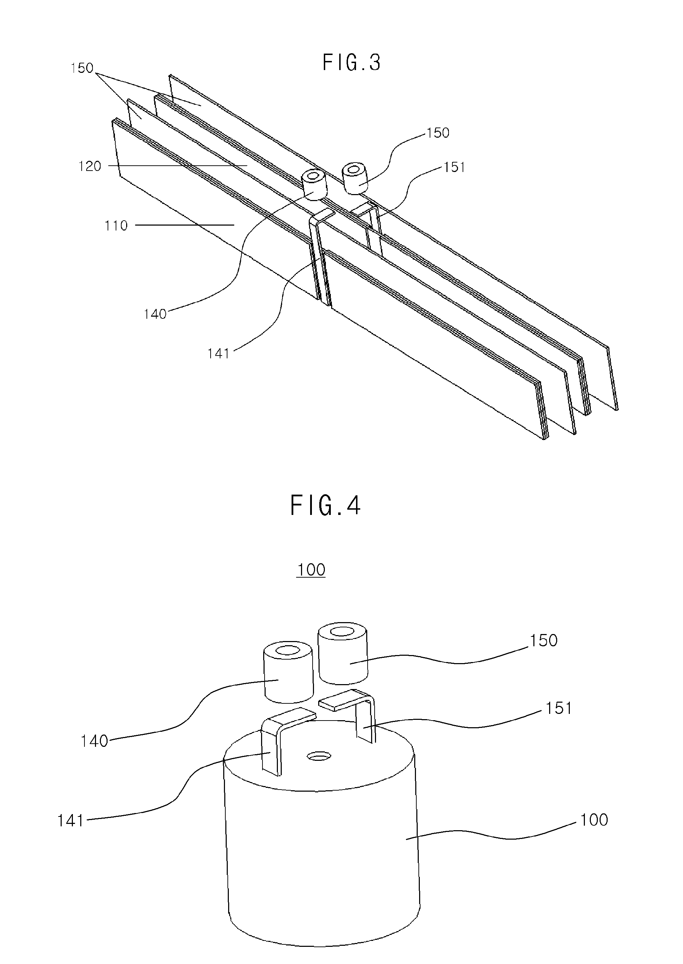

FIG. 3 is a perspective view showing an arrangement of an electrode and a terminal in a unit cell.

As shown in FIG. 3, the current collectors of the positive electrode 110 and the negative electrode 120 are connected with connection members (hereinafter, described as a case of a 'lead') 141 and 151 using a bonding method such as stitching and welding and these leads 141 and 151 may be connected with the terminals 140 and 150 by methods such as welding or riveting. Further, the separator 130 may be disposed between the positive electrode 110 and the negative electrode 120. The configuration of the unit cells may be applied to the electric energy storage device such as the secondary battery, the electric double layer capacitor, the aluminum electrolytic capacitor, the film capacitor, or the like.

FIG. 4 is a perspective view showing an arrangement of a jelly-roll type electrode assembly and a terminal.

The electrode assembly 100 shown in FIG. 4 may be prepared by winding the positive electrode 110, the negative electrode 120, the leads 141 and 151, and the separator 130 shown in FIG. 3, together and then, the leads 141 and 151 are each connected with the terminals 140 and 150.

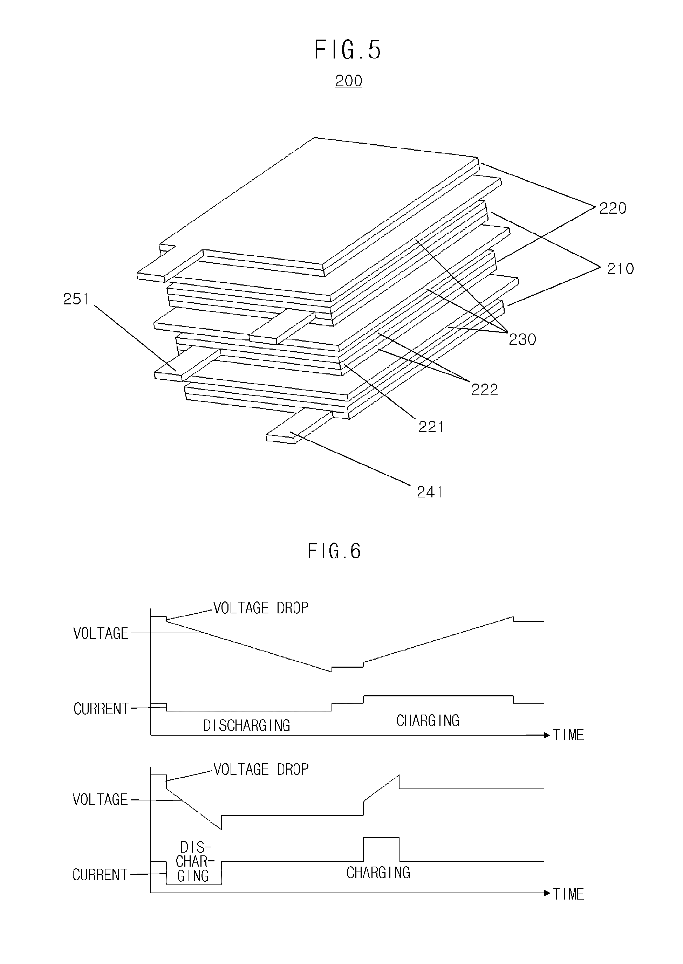

FIG. 5 is a perspective view showing a stacking arrangement of a multilayered electric double layer capacitor.

As shown in FIG. 5, the electrode is configured by forming active material layers 222 on both surfaces of a current collector 221 and the current collector 221 is further formed with a lead 251 connected to the terminal. The electrode assembly is prepared by stacking the positive electrode 210 and the negative electrode 220 and the separator 230, together, which are configured as described above. In this case, a positive lead 241 of the positive electrode 210 and a negative lead 251 of the negative electrode 220 may be connected to the terminals of each polarity.

As described above, the electric energy storage device has some degree of electric resistance according to a structure and a material thereof. When the electric energy storage device is used for applications using a small amount of current, for example, for memory backup, special problems are not caused even though the electric resistance of the electric energy storage device is large, but when the electric energy storage device is used as an industrial device using large power or a device for driving a car, various problems may be caused due to the electric resistance.

FIG. 6 is a graph showing voltage and current at the time of charging or discharging constant current of the above-mentioned electric double layer capacitor.

As shown, it can be appreciated that the charging or discharging time may be further shortened when the charging or discharging current is large. Further, when the charging or discharging current is increased, the voltage drop is increased due to the electric resistance of the electric double layer capacitor, such that it can be appreciated that the usable capacity of the electric double layer capacitor is degraded. This phenomenon is a general phenomenon that may occur in the electric energy storage device such as the electric double layer capacitor, the secondary battery. The electric resistance of the electric energy storage device may occur due to the structure and material of the electric energy storage device.

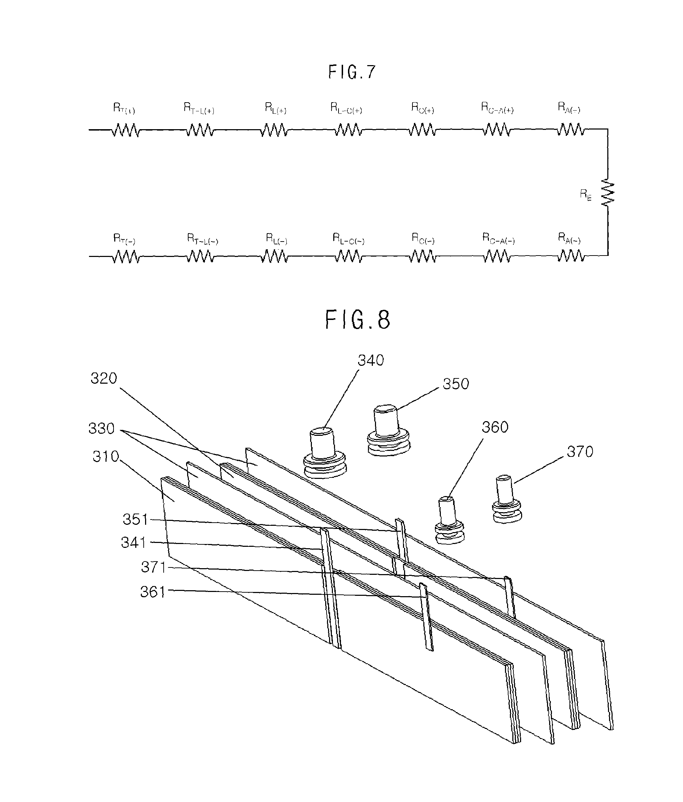

FIG. 7 is an equivalent circuit diagram of resistors of the electric energy storage device shown in FIG. 3.

In FIG. 7, RT(+) and RT(-) show the resistance of the positive terminal or the negative terminal. RT-L(+) and RT-L(-) are contact resistance that is generated at a connection surface between the terminal and the lead. RL(+) and RL(-) are the resistance of the positive lead or the negative lead, RL-C(+) and RL-C(-) are the contact resistance that is generated at the connection surface of the lead and the current collector of the electrode, and RC(+) and RC(-) are the resistance that is generated at the current collector of the terminal. RC-A(+) and RC-A(-) are the contact resistance between the current collector and the active material layer and RA(+), RA(-) are the resistance of the active material layer of the electrode. RE is the resistance due to the ion conductivity of the electrolyte.

Since the resistance RE due to the electrolyte is in inverse proportion to an electrode area, when the capacity of the electric energy storage device is reduced, the electrode area is reduced and thus, RE is increased and the larger the capacity of the electric energy storage device becomes, the smaller the RE becomes. Therefore, as the capacity of the electric energy storage device is increased, the weight of the remaining part excluding the RE from the entire resistance is increased. In addition, since the resistance RE due to the electrolyte depends on the characteristics of the electrolyte, there is a limitation in reducing the resistance RE.

The control of charging and discharging of the electric energy storage device having the above-mentioned structure is performed through voltage detected through the terminal, such that it is possible to accurately measure the voltage of the electrode in which the electric energy is stored through the terminal when current does not flow in the electric energy storage device. However, as shown in FIG. 7, the voltage drop occurs due to the resistance of the current moving path in the state in which current is applied to the electric energy storage device, such that it is difficult to accurately measure the voltage since the voltage includes both of the voltage of the electrode and the voltage drop component due to the resistance of the current moving path when the voltage is measured by using the terminal.

FIG. 8 is a perspective view showing an arrangement state of the electrode and the terminal of the electric double layer capacitor according to an exemplary embodiment of the present invention.

As shown in FIG. 8, the positive electrode 310 is connected to a positive current lead 341 and a positive voltage lead 361. The positive current lead 341 is a path through which current is transferred to the outside and is connected to the positive current terminal 340 and the positive voltage lead 361 is used to detect the voltage of the positive electrode 310 and is connected to a positive voltage terminal 360. Similarly, the negative electrode 320 is also connected with a negative voltage lead 371 connected to the negative voltage terminal 370 so as to detect the voltage of the negative electrode 320 and the negative current lead 351 connected to the negative current terminal 350. As described above, the voltage leads 361 and 371 are wound together with the positive electrode 310, the negative electrode 320, and the separator 330, thereby forming the electrode assembly.

As these electrodes 310 and 320 are farther away from the current leads 341 and 351, the resistance due to the current collector is increased and thus, current is smaller. As a result, at the electrode portion away from the current leads 341 and 351, the charging and discharging rates are reduced compared with those at the electrode portion close to the current lead.

Therefore, it is more preferable that the voltage leads 361 and 371 are connected to the electrode portion (for example, corner portions of the electrode as shown in FIG. 8) farthest away from the current leads 341 and 351 at the electrode. In addition, it is preferable that a material of the voltage leads 361 and 371 may use the same series material as the material of the current collector.

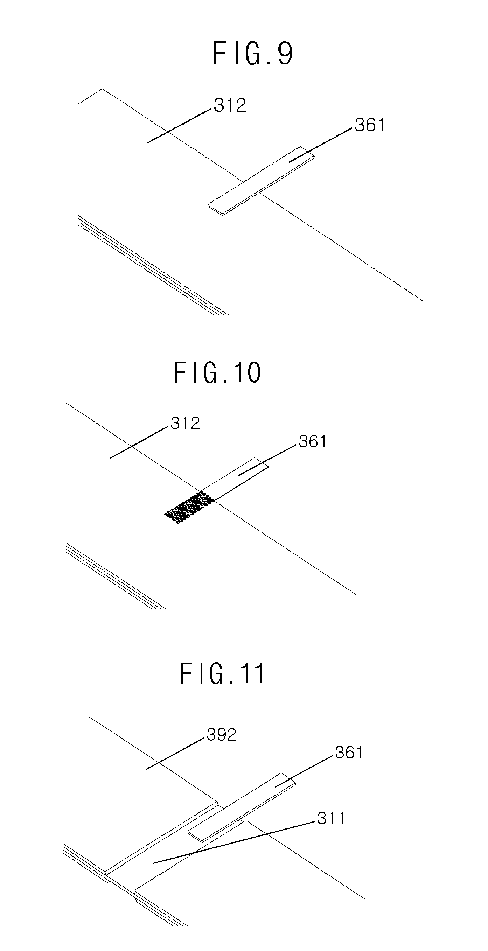

FIG. 9 is a schematic diagram showing a method of connecting the voltage lead to the electrode according to the exemplary embodiment of the present invention. Hereinafter, the positive electrode will be described as an example.

FIG. 9 shows the case in which the voltage lead 361 is connected to the active material layer 312 formed on the current collector of the electrode 310. The voltage lead 361 is to detect the voltage of the electrode 310. An extreme little amount of current flows into the voltage lead 361 in order to detect the voltage, such that the contact resistance between the voltage lead 361 and the active material layer has a slight effect on the voltage detection of the electrode. Therefore, the voltage lead 361 may be attached to the active material layer of the electrode by using a conductive adhesive or may be formed to be inserted into the defined position during the winding of the electrode 310 and the separator 330.

FIG. 10 shows the case using the voltage lead 361 where the portion located on the active material layer of the electrode 310 has a net shape. In addition, the portion located on the active material layer and the overall portion of the voltage lead 361 may be formed to have a net shape. By using the voltage lead 361, the voltage lead 361 may prevent that the movement of the ions present in the electrolyte is hindered even in the electric energy storage device using the electrolyte.

FIG. 11 shows the case where the voltage lead 361 is attached to the current collector 311 of the electrode 310, which may be formed by bonding the voltage lead 361 to the current collector of the electrode using a bonding means such as welding, stitching, soldering, conductive adhesive after removing the active material layer 312 of the electrode portion to which the voltage lead 361 is attached or manufacturing the electrode 310 without applying the active material layer to the portion to which the voltage lead 361 is attached.

Generally, when the active material in a powder type is used, the binder and the conductive material are used so as to form the active material layer 312 on the current collector 311. In most cases, since the binder is a nonconductor, the active material layer 312 has a predetermined amount of resistance. In order to minimize the resistance, the voltage lead 361 is connected to the active material layer 312 of the electrode.

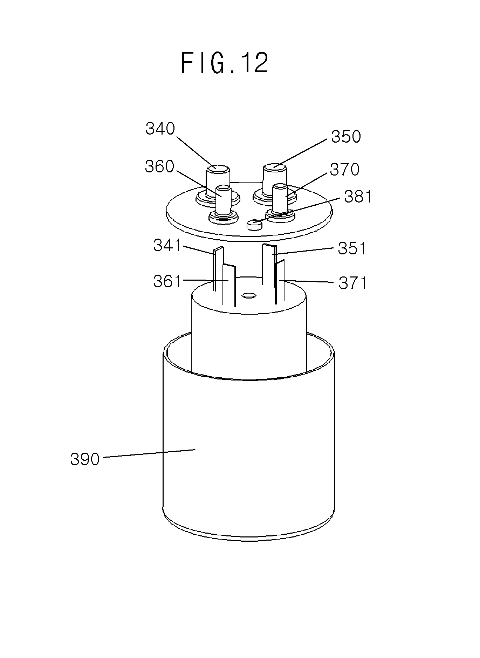

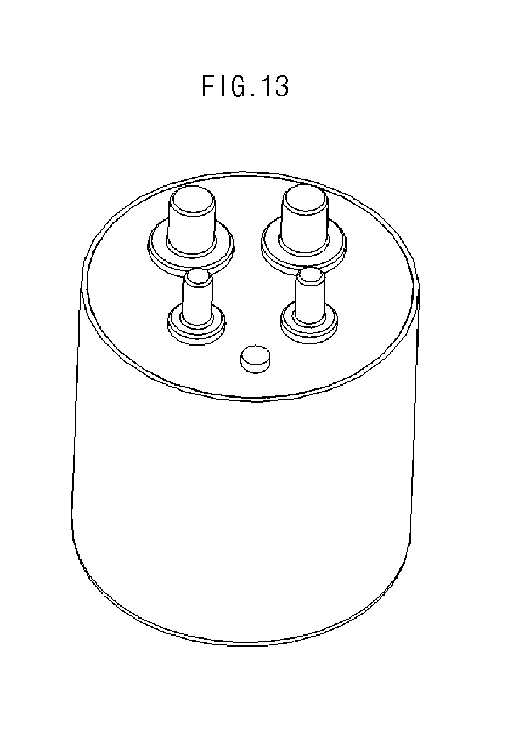

FIGS. 12 and 13 are perspective views of the structure of the electric double layer capacitor according to the exemplary embodiment of the present invention.

As shown in FIG. 12, the positive electrode 310, the negative electrode 320, and the separator 330 that are shown in FIG. 8 are wound together with the leads 341, 351, 361, and 371, thereby forming the electrode assembly. The positive current lead 341 and the negative current lead 351 of the electrode assembly are bonded to the positive current terminal 340 and the negative current terminal 350 of the terminal plate, respectively, using means such as welding, riveting, soldering, conductive adhesive, or the like, and the positive voltage lead 361 and the negative voltage lead 371 are also bonded to the positive voltage terminal 360 and the negative voltage terminal 370 of the terminal plate, respectively, using means using means such as welding, riveting, soldering, conductive adhesive, or the like.

After bonding each lead 341, 351, 361, and 371 to the corresponding terminals 340, 350, 360, and 370 and putting them in a case 390, and covering and sealing the case 390 with the terminal plate, the unit cells of the electric double layer capacitor may be completed by sealing an electrolyte injection hole 381 formed on the terminal plate into which the electrolyte is injected as shown in FIG. 10B.

As described above, the completed unit cells of the electric energy storage device have only a rated voltage of 2.5 to 3.6V. However, the case where the voltage required for the electric devices using electric energy is several ten voltages or several hundred voltages is very frequent. Therefore, in order to satisfy the above-mentioned required voltage, the unit cells of the electric energy storage device that are connected in series may be used.

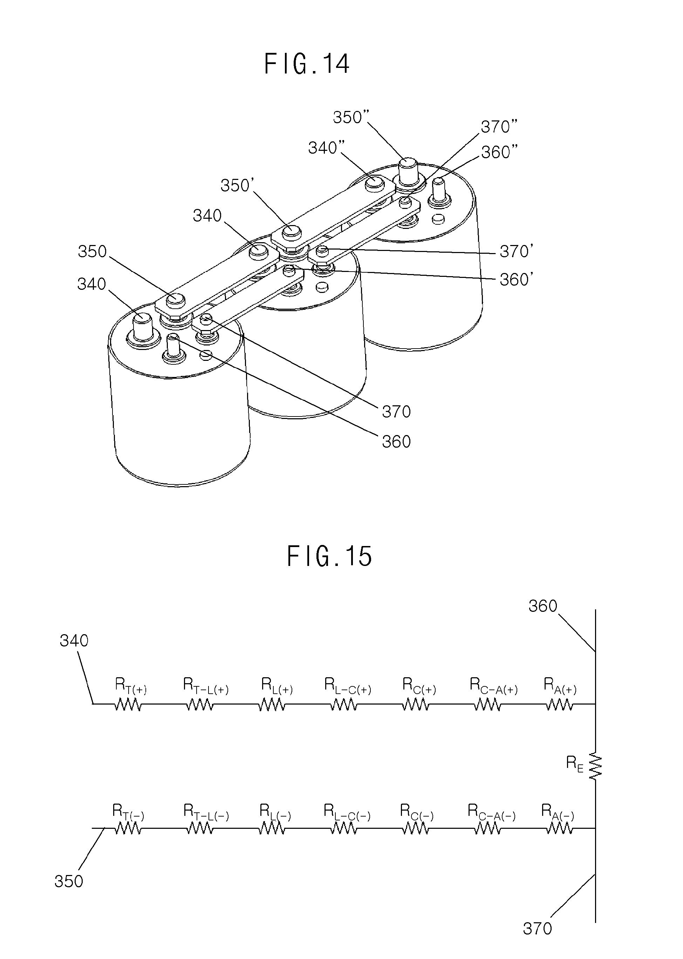

FIG. 14 is a perspective view of a serial electric double layer capacitor according to the exemplary embodiment of the present invention.

As shown in FIG. 14, in the serial electric double layer capacitor according to the exemplary embodiment of the present invention, the unit cells of the electric double layer capacitors of FIG. 10 are electrically connected in series using a conductor, such as metal, or the like, by a method such as welding, soldering, screw, or the like. Current terminals 350 and 350' are connected to current terminals 340' and 340" in series and voltage terminals 370 and 370' are connected to voltage terminals 360' and 360" in series.

As described above, after connecting the electric double layer capacitors in series, the voltage applied to the electric double layer capacitors connected in series other than the voltage drop component due to the resistance may be detected by supplying current to the current terminals 340 and 350" of the unit cells located at both ends and detecting voltage between the voltage terminals 360 and 370" of the unit cells located at both ends.

FIG. 15 is an equivalent circuit diagram of the resistors of the unit cells of the electric double layer capacitor shown in FIG. 10.

As shown in FIG. 15, the resistors of the unit cells of the electric double layer capacitor according to the exemplary embodiment of the present invention are the same as the resistors shown in FIG. 7, but the positive voltage lead 361 and the negative voltage lead 371 may be immediately connected to both ends of an electrolyte resistor RE since the voltage lead is disposed on the active material layer of the electrode. Therefore, voltage across the positive voltage terminal 360 and the negative voltage terminal 370 may include the voltage between the positive electrode and the negative electrode and only the voltage drop due to the electrolyte resistor.

Therefore, during the process of charging and discharging the electric double layer capacitor according to the exemplary embodiment of the present invention, the voltage measured across the positive current terminal 340 and the negative current terminal 350 and the voltage measured across the positive voltage terminal 360 and the negative voltage terminal 370 has a large difference. That is, as shown in FIG. 15, the voltage across the current terminals 340 and 350 includes the voltage drop component due to all the resistors, but the voltage across the voltage terminals 360 and 370 includes only the voltage drop component due to the electrolyte resistor.

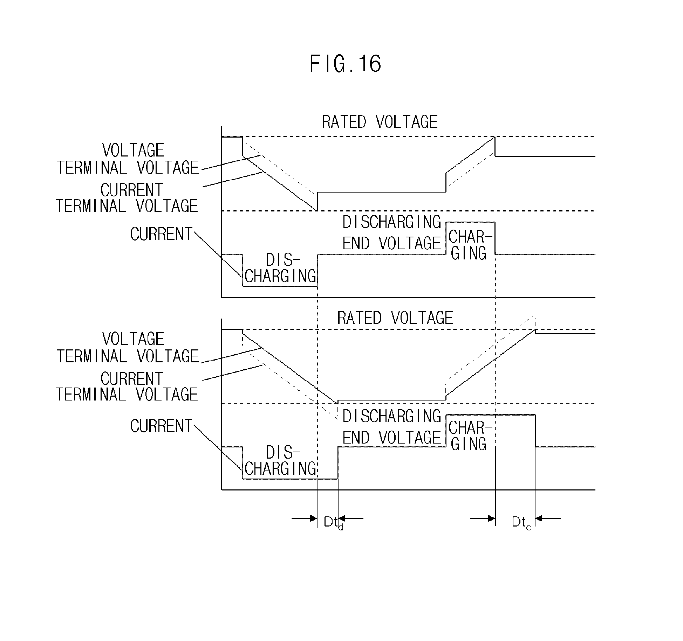

FIG. 16 is a graph showing a charging and discharging behavior of the electric double layer capacitor according to the exemplary embodiment of the present invention.

A graph (A) of FIG. 16 is a graph showing voltage and current in the case in which the charging and discharging of the electric double layer capacitor according to the exemplary embodiment of the present invention is controlled using the voltage across the current terminals 340 and 350 and A graph (B) of FIG. 16 is a graph showing voltage and current in the case in which the charging and discharging of the electric double layer capacitor according to the exemplary embodiment of the present invention is controlled using the voltage across the voltage terminals 360 and 370.

Comparing the graph (A) of FIG. 16A with the graph (B) of FIG. 16B during the discharging process, in the case of controlling the electric double layer capacitor using the voltage across the voltage terminals 360 and 370 shown in the graph (B), discharge time is longer by Δ Td. That is, when the electric double layer capacitor is discharged using the voltage across the voltage terminals 360 and 370 as the control voltage, it can be appreciated that the electric energy of the electric double layer capacitor may be more used. In addition, as the discharging current is increased, the voltage drop component due to the resistance included in the voltage across the current terminals 340 and 350 is also increased, such that the difference in the discharging time is more increased than in the case in which the discharging is performed using the voltage terminals 360 and 370.

In addition, comparing the charging processes of the graph (A) of FIG. 16 and the graph (B) of FIG. 16, the case in which the constant current is charged in the electric double layer capacitor using the voltage across the voltage terminals 360 and 370 as control voltage has a longer charging time than the case in which the voltage across the current terminals 340 and 350 is used as the control voltage. In addition, even in the voltage after the charging, the case in which the voltage across the voltage terminals 360 and 370 is used as the control voltage has a higher post-charging voltage than the case in which the voltage across the current terminals 340 and 350 is used as the control voltage. In addition, it is apparent that as the charging current is increased, the difference is further increased.

In particular, as can be appreciated from the process of charging the constant current shown in the graph (B), when the voltage across the voltage terminals 360 and 370 is charged as the control voltage, the voltage across the current terminals 340 and 350 may exceed the rated voltage. The reason is that even though the actual voltage of the electrode does not yet reach the rated voltage, the voltage across the current terminals 340 and 350 includes the voltage drop component due to the resistance across the current terminals.

Therefore, it can be appreciated that the case in which the electric double layer capacitor is controlled by using the voltage across the voltage terminals 360 and 370 is very effective. In addition, since the resistance across the voltage terminals 360 and 370 is much smaller than the resistance across the current terminals 340 and 350, the case in which the voltage across the voltage terminals 360 and 370 is used as the control voltage makes time constant much smaller and is very advantageous in high output.

In particular, when acceleration and deceleration as in an electric car, a hybrid car, or a subway is frequently performed, particularly, when a rapid charging such as regenerative braking is used, the exemplary embodiment of the present invention is very effective.

In most of the secondary batteries, the rated voltage and the discharging end voltage needs to be strictly observed so as to maintain the performance of the battery. More accurately, the voltage indicates the voltage of the electrode, but when current is applied to the terminal in the secondary battery using the terminal structure according to the related art, the voltage across the terminals includes the voltage of the electrode and the voltage drop component due to the resistance. Therefore, as the current applied to the terminal by the voltage drop due to the resistance is increased, the capacitance reduction is accelerated.

Therefore, even in the case of the secondary battery, when the terminal structure and the controlling method according to the exemplary embodiment of the present invention are used, it is possible to more accurately measure the voltage of the electrode while excluding the voltage drop component due to the resistance, such that the available capacity may be more increased than the related art. As described above, the exemplary embodiment of the present invention is very effective in large current discharging and large current charging even in the case of the secondary battery.

Although the exemplary embodiment of the present invention mainly uses the electric double layer capacitor among the electric energy storage devices, the present invention is not limited to only the electric double layer capacitor. In addition, the present invention may also be used for a capacitor that does not use the electrolyte.

The present invention may be used for the capacitor such as an electric double layer capacitor, an aluminum electrolytic capacitor, a film capacitor, or the like, and the electric energy storage device like a battery, a fuel cell, or the like, such as a lead acid battery, a nickel hydrogen battery, a nickel cadmium battery, a lithium ion battery, or the like.

A number of exemplary embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

### [Industrial Applicability]

The present invention may be used for the electric energy storage device capable of accurately measuring the actual voltage accumulated in the terminal while excluding the voltage drop due to the current.

## Claims

1. An electric energy storage device, comprising:
an electrode in which electric energy is stored;
a current terminal connected to the electrode and applied with current; and
a voltage terminal connected to the electrode and used for voltage detection,
wherein an operation of the electric energy storage device is controlled by using voltage detected using the voltage terminal as control voltage.

2. The electric energy storage device of claim 1, wherein the voltage terminal is connected to an active material layer of the electrode by using a connection unit.

3. The electric energy storage device of claim 1, wherein the voltage terminal is connected to a current collector of the electrode using the connection unit.

4. The electric energy storage device of claim 1, wherein a material of the connection unit of connecting the voltage terminal to the electrode is the same series material as the current collector of the electrode.

5. The electric energy storage device of claim 1, wherein the connection unit of connecting the voltage terminal to the electrode has a net shape.

6. The electric energy storage device of claim 1, wherein the connection unit of connecting the voltage terminal to the electrode is connected to a portion of the electrode where electric resistance is largest from the current terminal.

7. An electric energy storage device, wherein a plurality of electric energy storage devices each of which includes an electrode in which electric energy is stored; a current terminal connected to the electrode and applied with current; and a voltage terminal connected to the electrode and used for voltage detection are connected in series, and
the current terminal is connected to another current terminal in series and the voltage terminal is connected to another voltage terminal in series.

8. The electric energy storage device of claim 7, wherein an operation of the electric energy storage device is controlled using voltage detected by the voltage terminals of the electric energy storage devices connected in series.
